# EUROPEAN PATENT APPLICATION

(11) **EP 4 280 816 A1**
(43) Date of publication of application: **22.11.2023**
(21) Application number: 23173796.6
(22) Date of filing: 16.05.2023
(51) Int. Cl.: H05B 6/06

(54) **CONTROL SYSTEM AND METHOD FOR ACTIVE HEATING CONTROL**

(30) Priority: 16.05.2022 US 202217745163
(71) Applicant: Whirlpool Corporation, Benton Harbor, MI 49022 (US)
(72) Inventor: Mattioni, Marco, 21024 Cassinetta di Biandronno (VA) (IT); Tarantino, Giuseppe, 21024 Cassinetta di Biandronno (VA) (IT)
(74) Representative: PGA S.p.A.

(57) **Abstract**

A heating assembly for a cooking appliance includes at least one induction coil (16). A drive circuit (18) is configured to control a coil current (60) through the at least one induction coil (16). The drive circuit (18) includes a first switching circuit (34) operable to conduct the coil current (60) and a second switching circuit (36) operable to conduct the coil current (60). A sensing circuit (20) is configured to detect a polarity of the coil current (60). A control circuit (22) is configured to communicate a first activation signal to the first switching circuit (34) during a first activation period. The control circuit (22) is further configured to communicate a second activation signal to the second switching circuit (36) during a second activation period. The control circuit (22) is further configured to control a delay between the first activation signal and the second activation signal based on the polarity of the coil current (60).

## Description

### BACKGROUND OF THE DISCLOSURE

The present disclosure generally relates to a system and method for controlling a heating assembly of a cooking device and, more specifically, to a method for controlling driver circuitry for an induction coil of a cooking device.

### SUMMARY OF THE DISCLOSURE

According to one aspect of the present disclosure, a heating assembly for a cooking appliance includes at least one induction coil. A drive circuit is configured to control a coil current through the at least one induction coil. The drive circuit includes a first switching circuit operable to conduct the coil current during a first conducting period and a second switching circuit operable to conduct the coil current during a second conducting period different than the first conducting period. A sensing circuit is configured to detect a polarity of the coil current. A control circuit is in communication with the drive circuit and the sensing circuit. The control circuit is configured to communicate a first activation signal to the first switching circuit during a first activation period. The control circuit is further configured to communicate a second activation signal to the second switching circuit during a second activation period. The control circuit is further configured to control a delay between the first activation signal and the second activation signal based on the polarity of the coil current.

According to another aspect of the present disclosure, a method for controlling at least one induction coil of a heating assembly for a cooking appliance includes controlling a coil current through the at least one induction coil via a drive circuit. The drive circuit includes a first switching circuit operable to conduct the coil current during a first conducting period and a second switching circuit operable to conduct the coil current during a second conducting period different than the first conducting period. The method further includes monitoring a polarity of the coil current via a sensing circuit. The method further includes communicating a first activation signal to the drive circuit. The method further includes communicating a second activation signal to the drive circuit at a second time. The method further includes controlling a delay between the first activation signal and the second activation signal based on the polarity of the coil current.

According to yet another aspect of the present disclosure, a heating assembly for a cooking appliance includes at least one induction coil. The heating assembly includes a first switch and a second switch configured control a coil current through the at least one induction coil in alternation. A first diode is in antiparallel with the first switch. A second diode is in antiparallel with the second switch. A control circuit is in communication with the first and second switches. The control circuit is configured to activate the first switch for a first duration. The control circuit is further configured to deactivate the first switch at a first time to end the first duration. The control circuit is further configured to activate the second switch at a second time later than the first time for a second duration. The control circuit is further configured to control a delay between the first time and the second time. The second time corresponds to an end of a period during which the coil current flows through the second diode following deactivation of the first switch.

These and other features, advantages, and objects of the present disclosure will be further understood and appreciated by those skilled in the art by reference to the following specification, claims, and appended drawings.

### BRIEF DESCRIPTION OF THE DRAWINGS

In the drawings:
FIG. 1 is a block diagram of a control system for a heating assembly according to one aspect of the present disclosure;
FIG. 2 is an electrical schematic of an inverter circuit for an induction coil according to one aspect of the present disclosure;
FIG. 3A is an electrical schematic illustrating current flow through the inverter circuit of FIG. 2 in one operation state of the inverter circuit;
FIG. 3B is an electrical schematic illustrating current flow through the inverter circuit of FIG. 2 in one operation state of the inverter circuit;
FIG. 3C is an electrical schematic illustrating current flow through the inverter circuit of FIG. 2 in one operation state of the inverter circuit;
FIG. 3D is an electrical schematic illustrating current flow through the inverter circuit of FIG. 2 in one operation state of the inverter circuit;
FIG. 4 is a flow diagram of a method for identifying an operation state of an inverter circuit according to one aspect of the present disclosure;
FIG. 5A is an operational timing diagram of an inverter circuit controlled in a default control mode according to one aspect of the present disclosure; and
FIG. 5B is an operational timing diagram of an inverter circuit controlled in an adjusted control mode according to one aspect of the present disclosure.

The components in the figures are not necessarily to scale, emphasis instead being placed upon illustrating the principles described herein.

### DETAILED DESCRIPTION

The present illustrated embodiments reside primarily in combinations of method steps and apparatus components related to an adaptive heating control system for a cooking appliance. Accordingly, the apparatus components and method steps have been represented, where appropriate, by conventional symbols in the drawings, showing only those specific details that are pertinent to understanding the embodiments of the present disclosure so as not to obscure the disclosure with details that will be readily apparent to those of ordinary skill in the art having the benefit of the description herein. Further, like numerals in the description and drawings represent like elements.

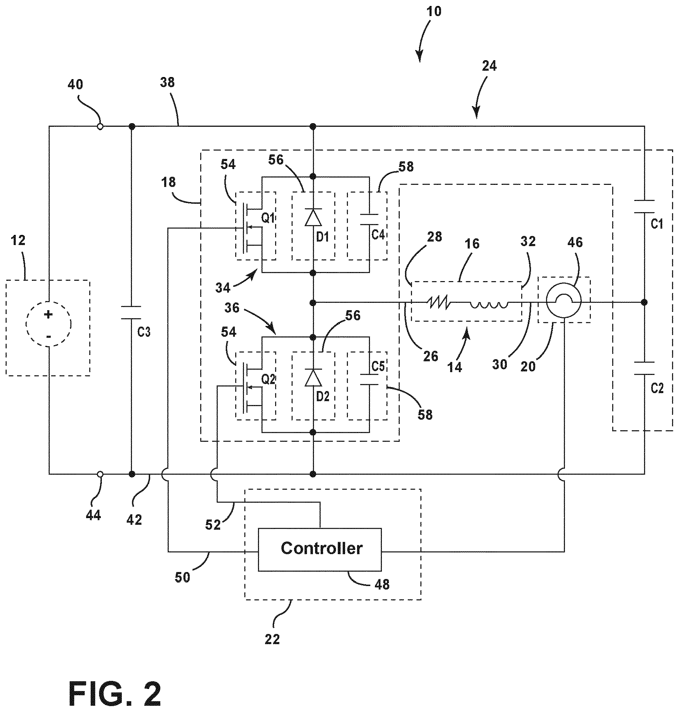

For purposes of description herein, the terms "upper," "lower," "right," "left," "rear," "front," "vertical," "horizontal," and derivatives thereof shall relate to the disclosure as oriented in FIG. 2. Unless stated otherwise, the term "front" shall referto the surface of the element closer to an intended viewer, and the term "rear" shall refer to the surface of the element further from the intended viewer. However, it is to be understood that the disclosure may assume various alternative orientations, except where expressly specified to the contrary. It is also to be understood that the specific devices and processes illustrated in the attached drawings, and described in the following specification are simply exemplary embodiments of the inventive concepts defined in the appended claims. Hence, specific dimensions and other physical characteristics relating to the embodiments disclosed herein are not to be considered as limiting, unless the claims expressly state otherwise.

The terms "including," "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element preceded by "comprises a ... " does not, without more constraints, preclude the existence of additional identical elements in the process, method, article, or apparatus that comprises the element.

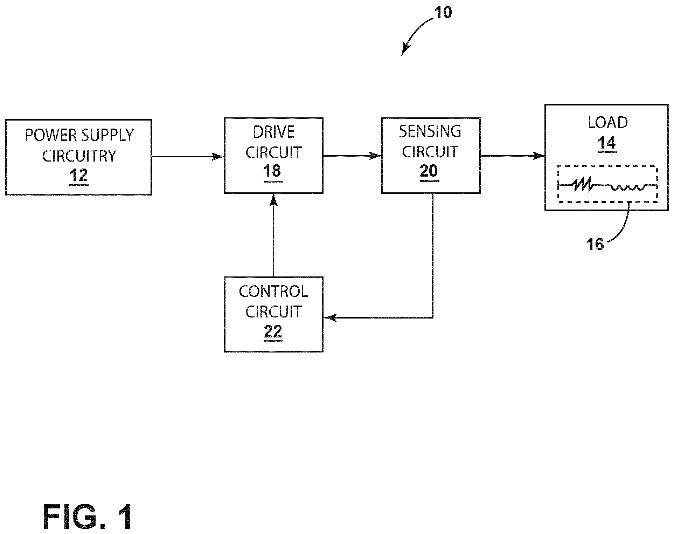

Referring to FIGS. 1 and 2, the present disclosure provides for a method and system 10 for controlling a heating assembly for operation with an induction cooking device. In general, the purpose of a heating control system 10 is to control an electrical current, or coil current, flowing through a heat source (e.g., one or more induction coils or loads 14) associated with a cooking surface of the cooking device. By controlling the current through one or more induction coils, an amount or rate of heat transfer from the cooking appliance to a cooking utensil disposed on the cooking surface may be adjusted. In some cases, control circuitry is employed to control activation signals that cause generation of the coil current.

The primary aspect of the disclosure relates to operation of the system 10 and related methods of actively and efficiently controlling active circuitry that energizes an induction coil or load 14 for an induction cooktop. The load 14 may be controlled via a user interface that is operable to receive a power level set by a user of the induction cooktop. In general, the improved efficiency of the system 10 may be provided by deactivating an active supply current to the induction coil or load 14 over a delay period. The delay period may be actively adjusted by the system 10 and timed to align the deactivation of the active circuitry (e.g., switches, transistors) with a dissipation period. During the dissipation period, energy stored in the system 10 (e.g., a freewheeling or flyback current) may supply operating energy to the induction coil or load 14. The detection and active control of the delay period may be particularly beneficial because the timing of the delay period may vary based on the load 14 associated with the induction coil for each cooking utensil and food load. In this way, the present disclosure may be implemented as a dynamic adjustment to reduce activation time of the active circuitry to improve efficiency and thermal performance. The improved thermal performance may improve reliability of the heating assembly by, in some cases, reducing electromagnetic noise caused by variations in duty cycles and/or reducing electrical energy waste that may degrade electrical components over time. As will be described in detail, the systems and methods of the present disclosure may achieve efficiency by employing identification and adjustment algorithms to detect whether the active or passive circuitry is energizing the induction coil and control the active circuitry based on which circuitry is energizing the induction coil.

Referring now to FIG. 1, an exemplary representation of the system 10 is illustrated. As shown, the system 10 may include power supply circuitry 12 that is operable to provide electrical power to a drive circuit 18. The drive circuit 18 is in communication with a load 14, such as a resonant load having an inductive load, such as induction coil 16 as illustrated. As will be described further herein, the drive circuit 18 may include active and passive electrical components that are configured to conduct electrical energy (e.g., current and/or voltage) through the inductive load 14. A sensing circuit 20 is provided between the drive circuit 18 and the load 14 for detecting properties of electrical signals associated with the load 14 (e.g., current flowing through the load 14 or provided to the load 14). A control circuit 22 is in communication with the sensing circuit 20 and the drive circuit 18 and is operable to control the drive circuit 18 based on the electrical properties detected by the sensing circuit 20. By actively monitoring the electrical feedback associated with the load 14, the system 10 employs the control circuit 22 to efficiently control the driver circuit 18 and reduce excess electrical energy in the system 10.

Referring now to FIG. 2, the system 10 is illustrated employing an inverter, or inverter circuit 24 operable to energize the inductive load 14. Although illustrated as a half bridge inverter, the inverter circuit 24 may be arranged in the form of another inverter circuit 24 operable to perform similar or the same method steps and operate with the similar or same control system 10 presently disclosed. Examples of other inverter circuits include full bridge inverter circuits, three phase bridge inverters, and the like. In the exemplary configuration, the inverter circuit 24 employs the power supply circuitry 12, the drive circuit 18, the sensing circuit 20, and the control circuit 22 previously described in reference to FIG. 1 to control an electrical current through the inductive load 14. The drive circuit 18 is in electrical communication with the induction coil 16 via a first coil node 26 electrically coupled at a first end 28 of the induction coil 16 and a second coil node 30 electrically coupled to a second end 32 of the induction coil 16.

The drive circuit 18 may include a first switching circuit 34 and the second switching circuit 36 each operable to conduct current through the induction coil 16 via the first coil node 26 in the second coil node 30. The first switching circuit 34 may be operable to conduct current during a first conducting period, and the second switching circuit 36 may be operable to conduct current during a second conducting period. The conducting periods may incorporate multiple operation mode times discussed further herein and may conduct current in either direction. For example, the switching circuits 34, 36 may be configured to conduct an electrical current from the first coil node 26 toward the second coil node 30 and from the second coil node 30 toward the first coil node 26 depending on an operation state of the inverter circuit 24. In this way, the drive circuit 18 may be operable to provide an alternating current through the induction coil 16, with properties of the alternating current (e.g., frequency, amplitude, or wavelength) being controlled by the control circuit 22.

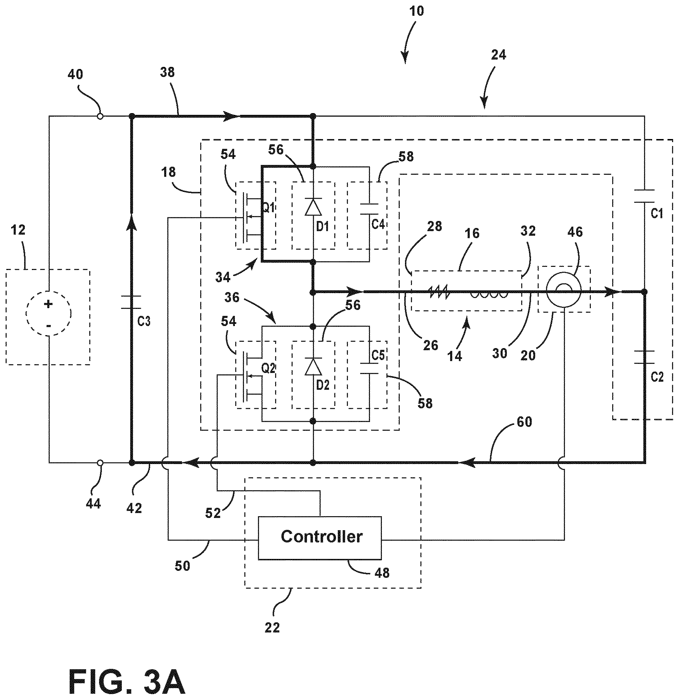

Still referring to FIG. 2, the drive circuit 18 may include a pair of drive capacitors C1, C2 that, together with the induction coil 16 and the power supply circuitry 12, form a pair of resonant circuits. The pair of drive capacitors C1, C2 include a first drive capacitor C1 and a second drive capacitor C2. The first drive capacitor C1 may be electrically interposed between the second coil node 30 and a first power node 38 in electrical communication with a first terminal 40 of the power supply circuitry 12. The second drive capacitor C2 may be electrically interposed between the second coil node 30 and a second power node 42 that is electrically connected to a second terminal 44 of the power supply circuitry 12. As will further be discussed in reference to FIGS. 3A-3D, the first drive capacitor C1 may be operable to conduct an electrical current from the first power node 38 toward the second coil node 30, and the second drive capacitor C2 may be operable to conduct an electrical current from the second coil node 30 toward the second power node 42. In this way, the drive circuit 18 may employ the first and second switching circuits 34, 36 with the first and second drive capacitors C1, C2 to form the AC signal experienced by the induction coil 16.

Still referring to FIG. 2, a capacitor C3 may be employed in parallel with the power supply circuitry 12 and be operable to smooth power dissipation between, for example, polarity changes of a power supply of the power supply circuitry 12. The capacitor C3 may be operable to filter high frequencies from the inverter circuit 24 and also, or alternatively, be operable to provide a free-wheel path during polarity transitions of the inverter circuit 24. According to some aspects, the power supply circuitry 12 may include a rectifier circuit (not shown) disposed between the power supply and the first and second terminals 40, 44 that is operable to convert an alternating current power signal to a direct current power signal. For example, the power supply circuitry 12 may include a full bridge rectifier or a half bridge rectifier for converting the AC signal to a DC signal to supply to the drive circuit 18. The particular type of power supply employed is intended to be nonlimiting and that the above described examples are nonlimiting.

With continued reference to FIG. 2, the sensing circuit 20 may include a current sensing device 46 in electrical communication with the second coil node 30 for sensing electrical properties of the induction coil 16. Additionally, or alternatively, the current detection device may be in electrical communication with the first coil node 26. The current detection device may include a current transformer or similar current detection device configured to detect a magnitude and/or polarity of the current to or from the induction coil 16, as well as an ammeter for detecting a level of the electrical current flowing to/from the induction coil 16. The particular current measurement device may be any electrical device operable to detect an amount and/or polarity (e.g., direction) of current flowing through an electrical conductor. By providing communication from the current detection device 46 to the control circuit 22, the control circuit 22 is operable to actively adjust the drive circuit 18 based on electrical properties of the induction coil 16 during use of the heating assembly.

As illustrated in FIG. 2, the control circuit 22 may include a controller 48 that is configured to process feedback data from the sensing circuit 20 and control the first and second switching circuits 34, 36 based on the feedback data. The feedback data may correspond to a level of electrical current flowing through the induction coil 16 and sensed by or measured by the sensing circuit 20. For example, the feedback data may include polarity data associated with the polarity of the electrical current flowing through the induction coil 16, a magnitude of the electrical current flowing through the induction coil 16, and the like. The controller 48 may include a processor and a memory that is configured to store instructions that, when executed by the processor, cause the controller 48 to perform various functions related to controlling the drive circuit 18. For example, the controller 48 may be configured to control at least one output signal to be communicated along at least one control node 50, 52 to the drive circuit 18. For example, a first control node 50 may electrically connect the controller 48 with the first switching circuit 34 and be operable to communicate a first output thereto. A second control node 52 may electrically connect the controller 48 with the second switching circuit 36 and be operable to communicate a second output thereto. As will be described further herein, the first and second outputs may generally correspond to a control signal communicated to the drive circuit 18, which may be in the form of at least one pulse width modulation (PWM) signal configured to control an activation time of the first and second switching circuits 34, 36, respectively. Accordingly, the control circuit 22 is configured to control the drive circuit 18 actively based on the feedback from the sensing circuit 20.

Referring more particularly to the switching circuits 34, 36 depicted in FIG. 2, each switching circuit 34, 36 may include a switching device 54, a rectification device 56, and a smoothing device 58. In general, each switching circuit 34, 36 is a parallel circuit, having the switching device 54 in parallel with the rectification device 56 and each of the rectification device 56 and the switching device 54 in parallel with the smoothing device 58. As will be described further herein with reference to FIGS. 3A-3D, the first switching circuit 34 may be operable to conduct electrical current between the first power node 38 and the first coil node 26, and the second switching circuit 36 may be operable to conduct electrical current between the second power node 42 and the first coil node 26. The first and second switching circuits 34, 36 may be operable to conduct electrical current at different times to avoid electrically overloading the induction coil 16. For example, the controller48 may be operable to activate the switching device 54 of the first switching circuit 34 at a different time than activation of the switching device 54 of the second switching circuit 36.

According to some aspects of the disclosure, each switching device 54 may be any electrical component operable to control an electrical current between two nodes via an on state and off state of the switching device 54. For example, the switching device 54 of either or both of the first and second switching circuits 34, 36 may be a transistor (e.g., a first transistor Q1 and a second transistor Q2). As depicted, the transistor may be an insulated-gate bipolar transistor (IGBT), though any one of various types of transistors may be employed, such as a bipolar junction transistor, a field effect transistor, or any other solid-state switching device, such as a solid-state relay, etc. According to some aspects, the rectification device 56 may be any electrical component that is operable to conduct an electrical current in a first direction and limit electrical current from flowing in a second opposing direction. For example, the rectification device 56 of either or both of the first and second switching circuits 34, 36 may be a diode (e.g., a first diode D1 and a second diode D2). As illustrated, the first diode D1 may be positioned to limit current flow through the first diode D1 in a direction from the first power node 38 to the first coil node 26 and allow current flow in a direction from the first coil node 26 to the first power node 38. The second diode D2 may be operable to conduct electrical current through the second diode D2 in a direction from the second power node 42 to the first coil node 26.

In some examples, the first diode D1 may be antiparallel to the first switch (e.g., first transistor Q1), and the second diode D2 may be antiparallel to the second switch (e.g., second transistor Q2). For example, the first switch Q1 may be configured to conduct current to flow from the first power node 38 toward the first coil node 26 when energized, and the first diode D1 may be configured to conduct current to flow from the first coil node 26 toward the first power node 38 when there is a forward threshold voltage across the first diode D1. Similarly, the second switch Q2 may be configured to conduct current to flow from the first coil node 26 toward the second power node 42 when energized, and the second diode D2 may be configured to conduct current to flow from the second power node 42 toward the first coil node 26 when there is a forward threshold voltage across the second diode D2. The first and second switches Q1, Q2 may be connected to the resonant load (e.g., induction coil 16) and configured to supply the resonant load with an electric current in alternation.

Each diode D1, D2 may be operable to conduct electrical current once a threshold voltage across either respective diode D1, D2 is met. For example, the first diode D1 may be operable to conduct electrical current from the first coil node 26 to the first power node 38 when a voltage between the first coil node 26 and the first power node 38 is at least 0.7 V, and the second diode D2 may be operable to conduct electrical current from the second power node 42 to the first coil node 26 when the voltage from the second power node 42 to the first coil node 26 is 0.7 V or greater. In operation, the first and second diodes D1, D2 may act as passive conduction devices, or passive circuitry, that maintain an electrical current through the induction coil 16 following deactivation of one or more of the first and second transistors Q1, Q2.

With continued reference to the switching circuits 34, 36 in FIG. 2, the smoothing device 58 may be any electrical component operable to store electrical energy in response to a voltage difference (e.g., an electrical potential across the smoothing device 58) and discharge that electrical energy when the electrical potential is reduced and/or removed or omitted. For example, the smoothing device 58 for either or both of the first and second switching circuits 34, 36 may be a capacitor (e.g., a first smoothing capacitor C4 and a second smoothing capacitor C5). The first smoothing capacitor C4 may be operable to smooth power dissipation during transition between conducting and nonconducting states of the first switching circuit 34, via, for example, the first transistor Q1 conducting electrical current and/or the first rectification device 56 (e.g., the first diode D1) conducting electrical current. Similarly, the second capacitor C5 may be operable to smooth power dissipation during transition between conducting and nonconducting states of the second switching circuit 36 via, for example, the second switching circuit 36 conducting electrical current and/or the second rectification device 56 conducting the electrical current. In this way, the first and second smoothing devices 58 may be operable to smooth an electrical current signal to/from the induction coil 16 to form a continuous alternating current signal through the induction coil 16.

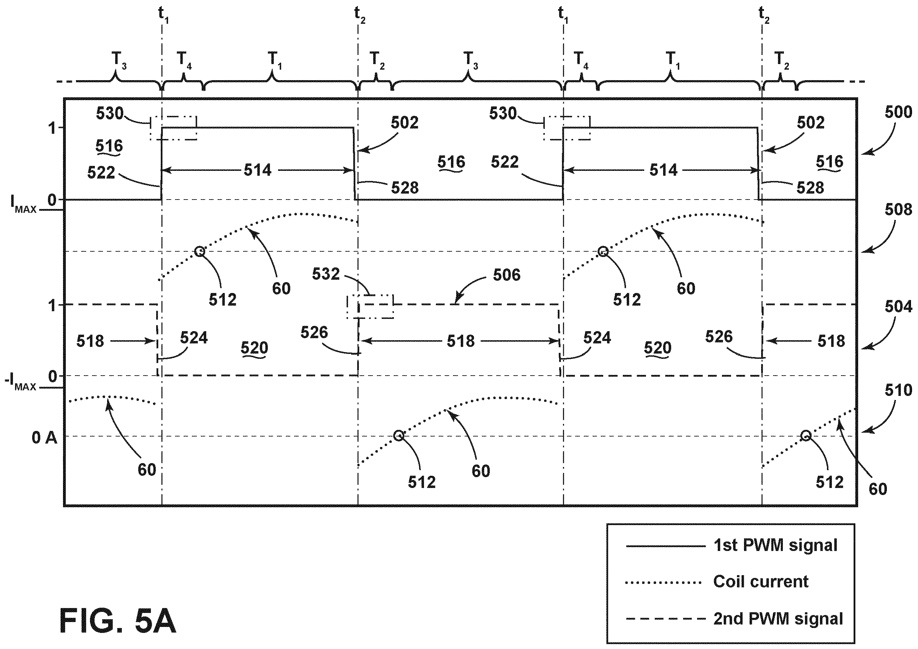

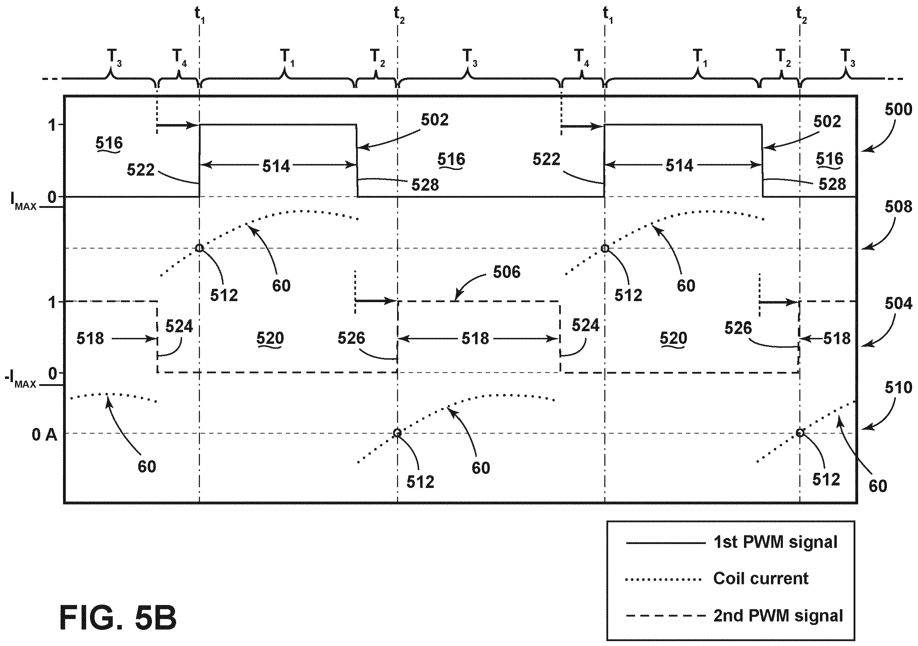

Referring now to FIGS. 3A-3D, various operation states of the inverter circuit 24 are depicted having a coil current 60 flowing through the inverter circuit 24. A first operation state of the inverter circuit 24 is generally illustrated in FIG. 3A and corresponds to activation of the first switching device (e.g., the transistor Q1). During the first operation state, the coil current 60 flows from the first power node 38, through the first transistor Q1 to the first coil node 26, and from the first coil node 26 through the induction coil 16 to the second coil node 30. The second drive capacitor C2 conducts the coil current 60 to flow from the second coil node 30 to the second power node 42, and capacitor C1 conducts the coil current 60 to flow from the second power node 42 back to the first power node 38. In the first operation state, the coil current 60 has a first polarity (e.g., a positive current). As will be demonstrated in view of FIGS. 5A and 5B, the coil current 60 may take the form of an alternating current signal during the first operation state, such that a start of an activation period of the first transistor Q1 may correspond to a magnitude, or intensity, of the coil current 60 increasing, and an end of the activation period may correspond to the magnitude of the coil current 60 decreasing.

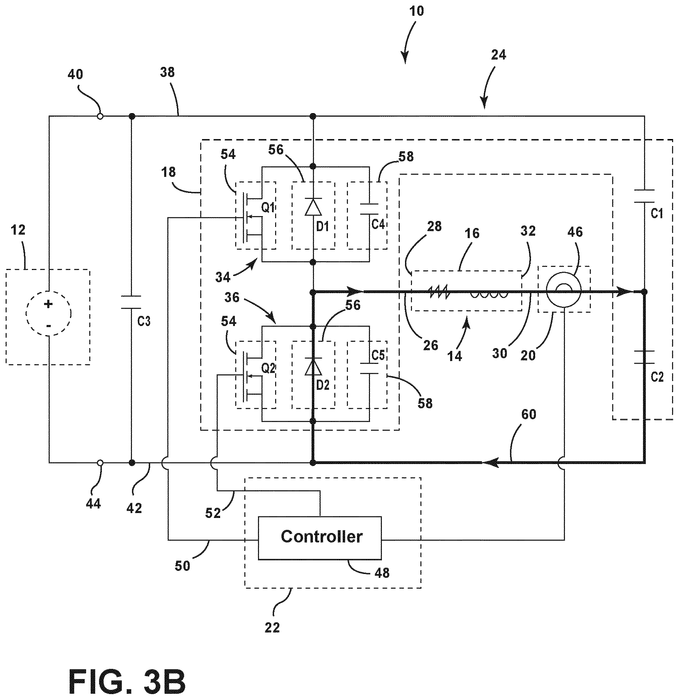

FIG. 3B demonstrates a second operation state of the inverter circuit 24 that may directly follow the first operation state following deactivation of the first transistor Q1. In the second operation state, the second diode D2 may conduct the coil current 60 from the second power node 42 through the second diode D2 to the first coil node 26, then through the induction coil 16 to the second coil node 30. The second drive capacitor C2 may conduct the coil current 60 to flow from the second coil node 30 back to the second power node 42 in the second operating state. The second diode D2 may conduct the coil current 60 upon deactivation of the first transistor Q1 due to a voltage potential across the second power node 42 and the first coil node 26. According to some aspects, the second operation state may last for a period of time significantly less than a duration of the first operation state (e.g., greater than 90% less, 80% less, 70% less, 50% less, 20% less, 10% less, etc.). In this way, the second diode D2 may operate as a freewheeling diode, or flyback diode, to conduct the coil current 60 with the same or similar polarity of the coil current 60 during the first operation state. It is contemplated that the time that the second diode D2 conducts the coil current 60 may be referred to as a diode time, and in particular a second diode time.

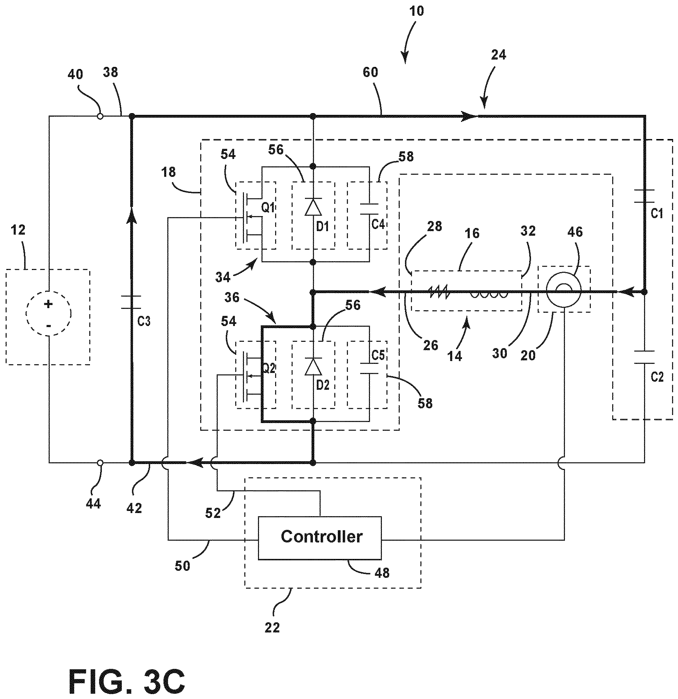

Following the second operation state, a third operation state of the inverter circuit 24 may occur and is generally depicted in FIG. 3C. As shown in the third operation state, the coil current 60 flows in an opposing direction relative to the direction of the coil current 60 in the first and second operation states. In this way, the coil current 60 may have a second polarity (e.g., a negative polarity) such that current flows from the second power node 42 toward the first coil node 26. During the third operation state, the second transistor Q2 is activated to cause the coil current 60 to flow from the first power node 38, through the first driving capacitor C1 to the second coil node 30, and through the induction coil 16 to the first coil node 26. The coil current 60 further flows from the first coil node 26 to the second power node 42 through the second transistor Q2, and through capacitor C1 back to the first power node 38. Consistent with the other operation modes, the third operation mode is operable to cause an alternating current signal through the induction coil 16. For example, a start of the activation period of the second transistor Q2 may correspond to the magnitude of the coil current 60 increasing, and an end of the activation period may correspond to the magnitude of the coil current 60 decreasing.

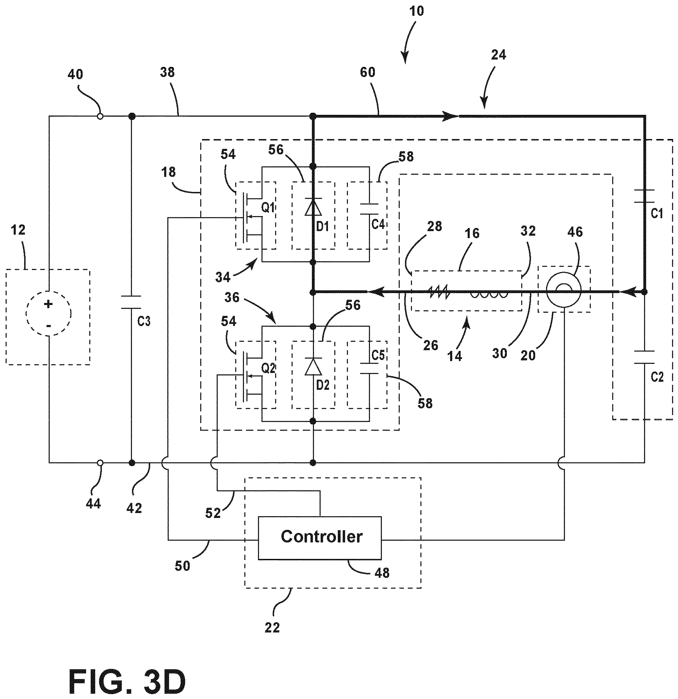

Referring now to FIG. 3D, a fourth operation state of the inverter circuit 24 is depicted having the coil current 60 flow through the first diode D1, with the coil current 60 having the second polarity. The fourth operation state may follow the third operation state, such that when the second transistor Q2 is deactivated, the coil current 60 is configured to flow through the second diode D2 due to a positive electrical potential across the second diode D2 exceeding the threshold voltage previously described. In this way, the first diode D1 may operate as a freewheeling diode, or flyback diode, that conducts the coil current 60 with the same or similar polarity of the coil current 60 of the third operation state. In the fourth operation state, the first diode D1 may conduct the coil current 60 from the first coil node 26 through the first diode D1 to the first power node 38, then through the first drive capacitor C1 to the second coil node 30, then from the second coil node 30 through the induction coil 16 to the first coil node 26. Similar to the second diode D2 in the second operation state, the fourth operation state may last for a period of time significantly less than a duration of the third operation state. It is contemplated that the time that the first diode D1 conducts the coil current 60 may be referred to a diode time, and in particular a first diode time.

In operation, the control circuit 22 is configured to control the switching devices 54 in a manner that causes the inverter circuit 24 to transition between the first and fourth operation states sequentially (e.g., from the first operation state to the second operation state, from the second operation state to the third operation state, from the third operation state to the fourth operation state, from the fourth operation state to the first operation state, and so on). In particular, the control system 10 and methods disclosed herein are operable to actively control the activation time of the switching devices 54 (e.g., transistors Q1, Q2) based on the electrical properties detected via the sensing circuit 20. The control circuit 22 may employ the controller 48 to determine which operation state the inverter circuit 24 is in and control the drive circuit 18 based on the detected operation state. By determining the operation state and, in turn, determining which electrical component is conducting the coil current 60 (e.g., the first transistor Q1, the first diode D1, the second transistor Q1, or the second diode D2), the controller 48 may identify a period of time in which electrical energy is being wasted and/or unnecessarily converted to thermal energy.

In particular, the controller 48 may be configured to determine a duration in which one of the switching devices 54 is on but not conducting the coil current 60. In response to determining this duration, the controller 48 may be configured to control a subsequent activation period to either begin or terminate at a target time. In this way, the systems and methods employed in the present disclosure may be operable to control a timing of an activation signal for the drive circuit 18 to improve thermal and/or electrical efficiency of the inverter circuit 24.

With continued reference to FIGS. 3A-3D, the second and/or fourth operating states of the inverter circuit 24 may take place simultaneously with activation of one of the switching devices 54. For example, during at least a portion of the second operation, the second transistor Q2 may be activated. In this example, activation of the second transistor Q2 may result in the first diode D1 continuing to conduct the coil current 60 and the second transistor Q2 not conducting the coil current 60 for at least a period of the second operation state due, at least in part, to the electrical characteristics employed in the second transistor Q2. For example, the second transistor Q2 may be an insulated-gate bipolar transistor (IGBT) that has unidirectional properties for electrical current. By including either or both of the switching devices 54 (e.g., transistors Q1, Q2) as an IGBT, activation of either of the active operation modes (e.g., the first or third operation state) while either of the first rectification devices 56 is conducting the coil current 60 may not cause overloading or sudden polarity shifts in current applied to the induction coil 16. However, activation of either of the first and second switching devices 54 while one or more of the rectification devices 56 are conducting may result in wasted electrical energy that the systems and methods disclosed herein may be employed to remedy. Accordingly, the control circuit 22 may be configured to cause passive activation modes (e.g., the second operation state or the fourth operation state) to correspond to a dead time in which neither of the switching devices 54 are activated.

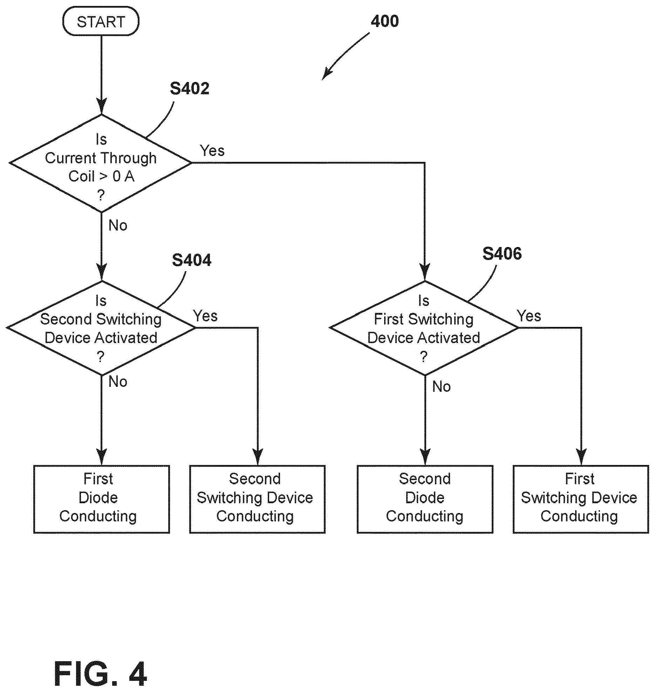

Referring now to FIGS. 4, 5A, and 5B, exemplary methods and routines may be performed by the system 10 to achieve efficient control over the induction coil 16. For example, the controller 48 of the control circuit 22 may be configured to execute an identification routine and/or an adjustment routine. The identification routine, as described in reference to method steps or data models (see e.g., FIGS. 4 and 5A, respectively), may be performed/employed to identify an operation state of the inverter circuit 24. The adjustment routine (see e.g., FIG. 5B) may be executed to control the drive circuit 18 based on the operation states identified in the identification routine. In general, the identification steps may occur at the same time as, close to, or subsequent to the adjustment steps to provide for dynamic control of the drive circuit 18 and improve efficiency of the system 10.

Referring now to FIG. 4 more particularly, a method 400 for identifying the various operating states of the system 10 is depicted. The method 400 includes determining a coil current 60 polarity of the inverter circuit 24. For example, the control circuit 22 may employ the controller 48 to determine whether current through the induction coil 16 is positive or negative at step S402. In some instances, the controller 48 may receive an electrical signal from the sensing circuit 20 indicating the magnitude and/or the polarity of the coil current 60 during performance of step S402. Once the polarity of the current is identified at step S402, the controller 48 may be configured to determine whether (and which of) the first and/or second switching devices 54 are activated. For example, if the coil current 60 is less than zero amperes (e.g., a negative polarity), then the second transistor Q2 is monitored to determine whether the second transistor Q2 is in an activated state at step S404. If the coil current 60 is greater than zero amperes (e.g., a positive polarity), then the controller 48 may monitor the first transistor Q1 to determine whether it is activated at step S406.

The controller 48 may determine the state of either or both of the switching devices 54 based on whether or not the controller 48 is activating the first or second outputs. Other feedback may be incorporated to identify whether or not the first and/or second switching devices 54 are activated or deactivated. For example, another sensing circuit may be incorporated to be in communication with the controller 48 and the switching devices 54 to confirm proper activation of the first and second switching devices (e.g., transistors Q1, Q2). The activation state of each of the switching devices 54 (e.g., transistors Q1, Q2) are generally demonstrated in FIGS. 5A and 5B, with the activation state corresponding to a pulse of a PWM signal.

With continued reference to FIG. 4, if the coil current 60 polarity is negative and the second transistor Q2 is not activated, then the controller 48 may determine that the first diode D1 is conducting the coil current 60 and that the system 10 is in the fourth operation state. If the second transistor Q2 is determined to be activated and the coil current 60 polarity is negative, then the controller 48 may determine that the second transistor Q2 is conducting the coil current 60 and the system 10 is in the third operation state. Similarly, if the coil current 60 has a positive polarity and the first transistor Q1 is not activated, then the controller 48 may determine that the second diode D2 is conducting the coil current 60 and the system 10 is in the second operation state. If the first transistor Q1 is activated and the polarity of the coil current 60 is positive, then the controller 48 may determine the first transistor Q1 is conducting the coil current 60 and the system 10 is in the first operation state. By identifying which electrical component is conducting the coil current 60, the controller 48 may adjust one or both of the first and second outputs (e.g., the control signals) to add a delay, increase or decrease activation time of one or more pulse-width modulated signals to the drive circuit 18, adjust a rising edge of one or more pulse-width modulated signals to the drive circuit 18, adjust a falling edge of pulse-width modulated (PWM) signals, and the like via the adjustment routine/algorithm described in reference to FIG. 5B. In this way, the systems and methods disclosed herein may be operable to more efficiently control the inverter circuit 24.

Referring now to FIG. 5A, execution of the identification routine is depicted in the form of feedback signals communicated from the sensing circuit 20 and control signals communicated to the drive circuit 18. For example, a first plot 500 illustrates a first PWM signal 502 communicated to the first switching device (e.g., transistor Q1), and a second plot 504 illustrates a second PWM signal 506 communicated to the second switching device (e.g., transistor Q2). The first and second PWM signals 502, 506 may correspond to the first and second outputs previously described. A third plot 508 and a fourth plot 510 together form a representation of the coil current 60 flowing of the coil current 60 in response to activation and deactivation of the first and second switching circuits 34, 36. As illustrated, the coil current 60 is plotted along a noninverted axis (i.e., I_{MAX} placed above 0A) in the third plot 508, and the coil current 60 is plotted along an inverted axis (i.e., -I_{MAX} placed above 0A) in the fourth plot 510, such that the coil current 60 is represented by a combination of the third and fourth plots 508, 510. As demonstrated in the third and fourth plots 508, 510, the controller 48 may be configured to detect one or more zero crossing points, or the points at which the coil current 60 is approximately zero amps, via execution of the identification routine. The zero crossing points, or zero-voltage switching points/polarity change points, are generally illustrated at 512 on the third and fourth plots 508, 510. Detecting the zero crossing point 512 may correspond to step S402 of method 400.

With continued reference to FIG. 5A, one or more time intervals corresponding to one or more operation states of the inverter circuit 24 are illustrated corresponding to particular portions of the timing diagram. In the examples previously described with respect to FIGS. 3A-3D, the one or more operation states may include a total of four operation states, though it is contemplated that systems 10 including any number of switching circuits 34, 36 do not deviate from the system 10 of the present disclosure. Accordingly, a first time interval T₁ may correspond to the first operation state, a second time interval T₂ may correspond to the second operation state, and so on. As illustrated in the first plot 500, the first PWM signal 502 may include a plurality of first pulses 514 interspaced in time by a plurality of first deactivation state 516 of the first PWM signal 502. Similarly, the second plot 504 illustrates the second PWM signal 506 including a plurality of second pulses 518 interspaced in time by a plurality of second deactivation states 520 of the second PWM signal 506. Each of the plurality of first and second pulses 514, 518 may correspond to activation signals communicated to the drive circuit 18 at different times. In this way, the first activation signal may correspond to a high state of the first PWM signal 502, and the second activation signal may correspond to a high state of the second PWM signal 506.

Although FIG. 5A generally illustrates a 50% duty cycle for each of the first and second PWM signals 502, 506, it is contemplated that any duty cycle may be employed to control either of the switching devices 54. Further, although each first pulse 514 is illustrated in FIG. 5A as having a rising edge 522 occurring at a first time t₁ that is common to, or slightly following (e.g., due to inherent reaction or commutation time of the components), the timing of a falling edge 524 of the second pulse 518, and each second pulse 518 is illustrated as having a rising edge 522 occurring at a second time t₂ that is common to, or slightly following (e.g., due to inherent reaction or commutation time of the components), the falling edge 528 of the first pulse 514, either or both of the rising edge 522, 526 and the falling edge 524, 528 of either or both of the first and second PWM signals 502, 506 may be adjusted by the controller 48 in some examples. As will be further discussed in relation to FIG. 5B, for example, the rising edge 522 of one or more of the plurality of first pulses 514 and/or the plurality of second pulses 518 may be adjusted (e.g., delayed) to occur temporally proximate to the zero crossing point 512 when the coil current 60 is approximately zero amperes. The controller 48 may also be configured to delay a rising edge that follows a falling edge by a nominal delay, or a delay of one or more clock cycles, to ensure that the first and second switches Q1, Q2 are not energized simultaneously. Accordingly, a 50/50 duty cycle (as demonstrated in FIG. 5A) may incorporate the commutation time and the nominal delay.

In some examples, the system 10 may be employed to exploit the commutation time of the components (e.g., first and second switches Q1, Q2) by incorporating the commutation time into the adjustment delay further described in reference to FIG. 5B. For example, the particular transistors Q1, Q2 employed may have a switching time of between 0.5 µs and 1.3 µs and a nominal "dead time," and the adjustment routine may incorporate these times to identify one or more activation times. In some examples, the switching times may depend on a lifetime of the component or the lifetime of other components of the inverter 24. The controller 48 may incorporate lifetime data to compensate for variable life cycle data associated with the components to improve estimation of the zero crossing points 512. In this way, the system 10 may provide for an adaptive control scheme based on the lifetime of the components as well as the passive conducting times.

With continued reference to FIG. 5A, the second and third plots 504, 508 generally illustrate a magnitude and relative polarity of the coil current 60 across approximately two cycles of the control scheme disclosed herein. For clarity, the coil current 60 is illustrated in two separate plots (e.g., the third plot 508 and the fourth plot 510) to reflect the coil current 60 and relative polarity during a corresponding activation signal, with the coil current 60 shown in the third plot 508 corresponding to the activation signal of the first plot 500 and the coil current 60 shown in the fourth plot 510 corresponding to the activation signals of the second plot 504. As depicted, during operation of the exemplary inverter circuit 24, the detected current magnitude and/or the polarity may reflect the electrical qualities of an alternating current signal having a sinusoidal or semi sinusoidal shape. The frequency of the signal may be dependent upon the particular activation times for the first and second outputs (e.g., the first and second PWM signals 502, 506) to the first and second switches Q1, Q2, respectively, as well as electrical properties of the diodes D1, D2 and/or other components previously described.

Still referring to FIG. 5A, the second and fourth time intervals T₂, T₄ may correspond to periods of time in which the first and second transistors Q1, Q2 (respectively) are activated unnecessarily. For example, the coil current 60 illustrated in the second plot 504 is negative (e.g., below zero amps) at the first time t₁ in which the rising edge 522 of the first PWM signal 502 occurs. In particular, a first portion 530 of the first pulse 514 lasting from the rising edge 522 of the first pulse 514 and the falling edge 524 of the second pulse 518 until the zero crossing point may be ineffective to cause the coil current 60 to flow through the first switching device Q1. For example, the coil current 60 may be operable to flow through the second diode D2 in the fourth operation state during the fourth time interval T₄. Similarly, a second portion 532 of the second pulse 518 lasting from the rising edge 526 of the second pulse 518 and the falling edge 528 of the first pulse 514 until the zero crossing point 512 may be ineffective to conduct the coil current 60 through the second transistor Q2. The periods of time corresponding to the second and fourth operation states of the inverter circuit 24 may correspond to a period of generating thermal energy that is wasted and/or inefficient for control of the heating assembly.

It is contemplated that although only two cycles are illustrated in FIGS. 5A and 5B, the number of PWM signals across time for a given heat cycle or control scheme may vary widely. For example, the resulting alternating current signal from a 50/50 duty cycle may have a frequency of between 10 kHz and 60 kHz. In some particular examples, the frequency of the coil current 60 may be between 25 kHz and 60 kHz. In addition, the duty cycle of one of the first and second activation signals may or may not match the duty cycle of the other of the first and second activation signals. Exemplary duty cycle patterns of the present disclosure may include any combination of a duty cycle of the first activation signal and a duty cycle of the second activation signal. As previously described, the discharge time of the diodes D1, D2 may be a fraction of the activation times of the activation signals. For example, the passive conducting time (e.g., during the second or fourth operation states) may be between 20% and 1% of an immediately preceding activation time (e.g., the first or third operation states). In some examples, the diode time may be at least 5% of the activation time. In some examples, the diode time may be at least 10% of the activation time.

In general, the system 10 may adjust a delay between two activation signals (e.g., a first pulse 514 and a second pulse 518) to reduce or limit the time in which the activation circuitry is activated while the passive circuitry is conducting. The degree to which the delay is adjusted may be dependent on a number of factors, such as the transition time for a particular diode to conduct, which may be based on electrical characteristics of the diode. Other factors, such as the response time of the particular switching device (e.g., IGBT) employed may also impact the adjustment to the delay. As will be described in reference to FIG. 5B, the adjustment may be any amount of time based on pre-programmed instructions that relate to the zero-switching time. The adjustment may be updated over time based on live-feedback or fixed based on the particular target heating level for the heating assembly. It is contemplated that the adjustment algorithm may adjust the delay to align the rising edge 522 of a subsequent pulse close to the zero-crossing point 512 without moving beyond, or after, the zero-crossing point 512 to limit damage to the electrical components in some configurations.

According to some aspects of the present disclosure, the system 10 may be operable to actively control the drive circuit 18 either via a reaction algorithm or a sampling algorithm. For example, the controller 48 may be configured to identify a zero crossing point 512 of each cycle and reactively control or adjust the first and second PWM signals 502, 506 based on an actual change in polarity of the coil current 60. Due to the relatively high frequency control of the induction coil 16, the controller 48 may additionally or alternatively apply the sampling algorithm to gather historical data points in time in which the zero crossing point 512 occurs and control future pulses based on historical data.

For example, in one cycle, the controller 48 may determine that, upon deactivation of the first PWM signal 502, the second diode D2 conducts the coil current 60 for a first passive state duration. The controller 48 may then delay the next first pulse 514, or a subsequent first pulse 514, by an amount of time that corresponds to the first passive state duration following a falling edge 524 of the second PWM signal 506. The particular delay may or may not adjust the rising edge 522 of the first pulse 514 to be simultaneous with the zero point. For example, the controller 48 may adjust the rising edge 522 of the first pulse 514 to become closer to (e.g., slightly before) the zero crossing point 512 over time. The controller 48 may be operable to apply the same control structure to the second PWM signal 506 based on the zero crossing point 512 following a falling edge 524 of one or more of the second pulses 518. In this way, the controller 48 may accumulate historical data corresponding to passive state durations of the drive circuit 18. The controller 48 may be configured to store such historical data in a database and correlate the historical data with particular trends and/or associations with target duty cycles, ambient temperature, target temperature, resonant frequencies (based on induction and capacitor qualities), or various other factors that may impact discharge times of the rectification devices 56. In some examples, the controller 48 is configured to calculate a mean, median, mode, or other statistically-identifiable value of the zero-crossing time based on the historical data and control the later pulses based on the statistically-identifiable value.

In some examples, the controller 48 is configured to calculate one or more levels of process integration or process differentiation (e.g., integrals or derivatives) associated with the coil current 60. For example, the controller may calculate or identify a rate of change, or an instantaneous rate of change, of the coil current 60 that corresponds to a slope of the coil current 60 across time. Based on the rate of change, the controller 48 may determine or estimate the zero-crossing time. Consistent with the above examples, the controller 48 may estimate when the zero crossing point 512 (e.g., the polarity change) will occur by processing historical slope data (e.g., previously-calculated slopes) and associating the historical slope data with an estimated zero crossing point. In some examples, the controller 48 may associate the slope with a predicted crossing point of the coil current 60 and activate a subsequent activation signal approximately, or slightly prior to, when the predicted crossing point occurs. A rate of the rate of change (e.g., a second derivation of the coil current 60) may also be calculated by the controller to assist in estimation of the zero crossing point 512. In effect, the controller 48 may be configured to predict the zero crossing point 512 by comparing the coil current 60 to data models of sinusoidal or other periodic wave data. The data models may be modified or customized by the controller 48 based on sampling actual current through the induction coil 16 across several cycles. In these ways, the controller 48 may analyze the slope, rate of change of the slope, or other mathematical attributes of the coil current 60 to predict the polarity change/zero crossing point 512.

Referring now to FIG. 5B, an exemplary adjustment based on execution of the adjustment algorithm is illustrated in the form of a timing diagram similar to the timing diagram of FIG. 5A. As illustrated in FIG. 5B, the rising edge 522 of each first pulse 514 is commensurate with the zero crossing point 512 of the coil current 60 following deactivation of the second PWM signal 506. Similarly, the rising edge 526 of each second pulse 518 is commensurate with a zero crossing point 512 following the falling edge 528 of the first pulse 514. In this example, there may be a seamless transition in the coil current 60 from operation state to operation state while the duty cycle of each of the first and second PWM signals 502, 506 is reduced. Stated differently, the controller 48 may activate the switching devices 54 for less time than as illustrated in FIG. 5A, but produce the same or similar AC signal in the coil current 60. Accordingly, the example illustrated is consistent with various aspects of the methods and control system 10 of the present disclosure. As previously stated, although the adjustment illustrated is to each rising edge 522, 526 of the first and second pulses 514, 518, it is contemplated that a similar adjustment may be made to corresponding falling edges 524, 528 of the first and second pulses 514, 518. Further, it is contemplated that the adjustment shown in FIG. 5B is exemplary and nonlimiting, and that any adjustment may be made to the signals to cause the signals to exploit the diode conducting times for a time shorter than the second and fourth time intervals T₂, T₄. In some examples, the delay between activation signals may be controlled either at the start or end of each activation signal.

According to various aspects of the control algorithm, the control circuit 22 may be configured to adjust a timing of a falling edge 528 of the first PWM signal 502 and/or adjust a timing of a falling edge 524 of the second PWM signal 506 to control the delay between activation of the switching devices 54. The control circuit 22 may be further configured to calculate an interval between the first time t₁ and a change in the polarity of the coil current 60. The control circuit 22 may then be configured to adjust the second activation signal based on the change in polarity. It is contemplated that polarity may refer to a state of the coil current 60 (e.g., positive, negative, or no polarity).

It is contemplated that the PWM signals may have a plurality of cycles each defined by a pair of sequential first and second activation signals. Accordingly, the adjustment to the delay may be based on an interval between one or more of the plurality of cycles. In this way, the adjustment may take place every so many cycles (e.g., after 30 cycles) during which the coil current 60 is monitored to determine the duration the coil current 60 is conducting the coil current 60. The control circuit 22 may also be configured to estimate a polarity transition time of the coil current 60 based on the interval of one or more of the plurality of cycles, then adjust the second time t₂ (e.g., the time of the rising edge 526 of the second PWM signal 506) to be temporally proximate to the polarity transition time. In some examples, the adjustment may be limited to a time before the polarity transition time.

In some examples, a subsequent activation signal may be postponed following a preceding activation signal that is substantially equal to a diode conducting time, or a passive conducting time, when the diode conducting time is at least 5 percent of the preceding activation time. In some examples, the delay is implemented when the diode conducting time is at least 10 percent of the preceding activation time. Accordingly, the duration of the pulses 502, 506 may affect whether the delay is implemented via the adjustment routine. Further, the controller 48 may monitor a use time of the inverter 24 relative to a lifetime of the inverter 24 and employ or limit the delay based on the use time of the inverter 24. In cases where the diode time is nearly zero relative to the activation time, the controller 48 may not initiate the delay. In other examples, the controller 48 may apply the delay when the diode time is greater than 0 seconds in duration. In addition, the delay may be implemented to commence the subsequent activation signal at a time equal to the diode time, or substantially equal to the diode time.

According to some aspects, a method for controlling the inverter 24 includes providing the first and second switches Q1, Q2 in connection with a resonant load (e.g., induction coil 16) and supplying the resonant load with electric current in alternation (e.g., AC coil current 60). The method may further include providing the first diode D1 in antiparallel connection with the first switch Q1 and the second diode D2 in antiparallel connection with the second switch Q2. The method may further include executing (e.g., via the controller 48) recursive and/or sequential steps including activating the first switch Q1 for a first period time (e.g., T₁), deactivating the first switch Q1, activating the second switch Q2 for a second period of time (e.g., T₂), and deactivating the second switch Q2. The method may also include defining a first adjustable period of time starting from the time at which the first Q1 switch is deactivated and depending on the time duration (e.g., T₂), of the current flowing in the second diode D2 after the first switch has been deactivated. The method may further include defining a second adjustable period of time starting from the time at which the second switch Q2 is deactivated and depending on the time duration (e.g., T₄) of the current flowing in the first diode D1 after the second switch Q2 has been deactivated. The step of activating the second switch Q2 may be performed when the first adjustable period of time elapses. The step of activating the first switch Q1 may be performed when the second adjustable period of time elapses.

According to some aspects, a method for controlling the inverter 24 for the inductive load 14 includes activating a first switch Q1 of the inverter 24 to cause an electric current 60 to flow through the inductive load 14. The method further includes deactivating the first switch Q1 at a first time (e.g., an end of the first time interval T₁). The method further includes activating the second switch Q2 of the inverter 24 following deactivation of the first switch Q1. The method further includes deactivating the second switch Q2 at a second time (e.g., an end of the third time interval T₃). The method further includes conducting the electric current 60 through a first diode D1 antiparallel to the first switch Q1 during a first adjustable period starting at the second time and ending based on at least one time duration. The method further includes conducting the electric current 60 through a second diode D2 antiparallel to the second switch Q2 during a second adjustable period starting at the first time and ending based on the at least one time duration. The method further includes controlling activation of the second switch Q2 to align with when the first adjustable period elapses. The method further includes controlling activation of the first switch Q1 to align with when the second adjustable period elapses.

According to some aspects, the at least one time duration includes a first time duration (e.g., the fourth time interval T₄) of the electric current 60 flowing through the first diode D1, and the first adjustable time ends based on the first time duration.

According to some aspects, the at least one time duration includes a second time duration (e.g., the second time interval T₂) of the electric current 60 flowing through the second diode D2, and the second adjustable time ends based on the second time duration.

According to some aspects, the system 10 for controlling the inverter 24 includes a first switch Q1 and a second switch Q2 connected to a resonant load (e.g., a resistor in series with at least one inductor or capacitor). The resonant load may include an inductive load (e.g., induction coil 16). The first and second switches Q1, Q2 may be operable to supply the inductive load an electric current (e.g., coil current 60) in alternation. A first diode D1 may be in antiparallel connection with the first switch Q1. A second diode D2 may be in antiparallel with the second switch Q2. The system 10 further includes a control circuit 22 in communication with the first and second switches Q1, Q2. The control circuit 22 may further be configured to activate the first switch Q1 for a first period of time (e.g., T₁). The control circuit 22 may further be configured to deactivate the first switch Q1. The control circuit 22 may further be configured to activate the second switch Q2 for a second period of time (e.g., T₃). The control circuit 22 may further be configured to deactivate the second switch Q2. The control circuit 22 may further be configured to define a first adjustable period of time starting at the time the first switch Q1 is deactivated and depending on the time duration of the current flowing in the second diode D2 after the first switch Q1 has been deactivated. The control circuit 22 may further be configured to define a second adjustable period of time starting from the time at which the second switch Q2 is deactivated and depending on the time duration of the current flowing in the first diode D1 after the second switch Q2 has been deactivated. The control circuit 22 may further be configured to activate the second switch Q2 when the first adjustable period of time elapses. The control circuit may further be configured to activate the first switch Q1 when the second adjustable period of time elapses.

According to some aspects, a method for controlling the induction coil 16 of the heating assembly for a cooking appliance includes controlling the coil current 60 through the induction coil 16 via the drive circuit 18. The method may further include monitoring the polarity of the coil current 60 via the sensing circuit 20 and communicating the first activation signal to the drive circuit 18 until a first time. The method may further include communicating the second activation signal to the drive circuit 18 at a time after the first time, and then controlling the delay between the first activation signal and the second activation signal based on the polarity of the coil current 60. It is contemplated that the delay may be controlled based on an estimated transition time of the coil current 60 according to the historical data gathered.

In general, the present disclosure may provide for more accurate zero-voltage switching to reduce activation time of the switching device 54 of the drive circuit 18. The accuracy may be accomplished via a number of control methods described herein related to monitoring a sign of the coil current 60. By limiting power loss due to activation of the switching devices 54, thermal dissipation of the system 10 may be reduced. Accordingly, the system 10 of the present disclosure may exploit the energy stored in the rectification devices 56 (e.g., the diodes D1, D2) to increase efficiency.

According to one aspect of the present disclosure, a heating assembly for a cooking appliance includes at least one induction coil. A drive circuit is configured to control a coil current through the at least one induction coil. The drive circuit includes a first switching circuit operable to conduct the coil current during a first conducting period and a second switching circuit operable to conduct the coil current during a second conducting period different than the first conducting period. A sensing circuit is configured to detect a polarity of the coil current. A control circuit is in communication with the drive circuit and the sensing circuit. The control circuit is configured to communicate a first activation signal to the first switching circuit during a first activation period. The control circuit is further configured to communicate a second activation signal to the second switching circuit during a second activation period. The control circuit is further configured to control a delay between the first activation signal and the second activation signal based on the polarity of the coil current.

According to another aspect, the control circuit is configured to communicate the first activation signal to a first switching device of the first switching circuit and the second activation to a second switching device of the second switching circuit.

According to another aspect, the first activation signal corresponds to a high state of a first pulse-width modulation (PWM) signal and the second activation signal corresponds to a high state of a second PWM signal.

According to another aspect, the control circuit is further configured to adjust a timing of a rising edge of the second PWM signal to control the delay.

According to another aspect, the control circuit is further configured to adjust a timing of a falling edge of the first PWM signal to control the delay.

According to another aspect, the control circuit further calculates an interval between a falling edge of the first activation signal and a change in the polarity. The controller circuit adjusts the second activation signal based on the change in the polarity.

According to another aspect, the first and second activation signals correspond to pulse-width modulation (PWM) signals having a plurality of cycles each defined by a pair of sequential first and second activation signals.

According to another aspect, the adjustment to the delay is based further on the interval of one or more of the plurality of cycles.

According to another aspect, the control circuit further estimates a polarity transition time of the coil current based on the interval of the one or more of the plurality of cycles. The control circuit adjusts a rising edge of the second activation signal to be temporally proximate to the polarity transition time.

According to another aspect, the control circuit further includes a first diode and a second diode. The first diode is configured to conduct the coil current following deactivation of the second switching device and the second diode is configured to conduct the coil current following deactivation of the first switching device.

According to another aspect, the controller further determines that the coil current is being conducted via the second diode based on the polarity of the coil current and deactivation of the first switching device. The controller activates the second switching device in response to the second diode not conducting the coil current following deactivation of the first switching device.

According to another aspect, the first diode is in parallel with the first switching device and the second diode is in parallel with the second switching device.

According to another aspect, the first switching device is configured to conduct the coil current in a first direction through the at least one induction coil and the second switching device is configured to conduct the coil current in a second direction through the at least one induction coil, opposite the first direction.

According to another aspect, the control circuit is further configured to adjust the delay based further on a change in the polarity of the coil current.

According to another aspect, the control circuit is further configured to measure a diode time between deactivation of the second switching device and the first diode no longer conducting the coil current, calculate a ratio of the diode time to the second activation time, and postpone an activation of the first switching device based on the ratio of the diode time to the second activation time.

According to another aspect, the control circuit is further configured to postpone the activation of the first switching device when the ratio corresponds to the diode time being at least 5% of the second activation time. For example, the ratio may be 1:20.

According to another aspect of the present disclosure, a method for controlling at least one induction coil of a heating assembly for a cooking appliance includes controlling a coil current through the at least one induction coil via a drive circuit. The drive circuit includes a first switching circuit operable to conduct the coil current during a first conducting period and a second switching circuit operable to conduct the coil current during a second conducting period different than the first conducting period. The method further includes monitoring a polarity of the coil current via a sensing circuit. The method further includes communicating a first activation signal to the first switching circuit during a first activation period. The method further includes communicating a second activation signal to the second switching circuit during a second activation period. The method further includes controlling a delay between the first activation signal and the second activation signal based on the polarity of the coil current.

According to yet another aspect, the method calculates an interval between a falling edge of the first activation signal and a change in the polarity. The method adjusts the second activation signal based on the change in the polarity.

According to yet another aspect, the first and second activation signals correspond to pulse-width modulation (PWM) signals having a plurality of cycles each defined by a pair of sequential first and second activation signals.

According to yet another aspect, the adjustment to the delay is based further on the interval of one or more of the plurality of cycles.

According to yet another aspect, the control circuit is further configured to estimate a polarity transition time of the coil current based on the interval of the one or more of the plurality of cycles. The control circuit adjusts a rising edge of the second activation signal to be temporally proximate to the polarity transition time.

According to yet another aspect, a heating assembly for a cooking appliance includes at least one induction coil. The heating assembly includes a first switch and a second switch configured control a coil current through the at least one induction coil in alternation. A first diode is in antiparallel with the first switch. A second diode is in antiparallel with the second switch. A control circuit is in communication with the first and second switches. The control circuit is configured to activate the first switch for a first duration. The control circuit is further configured to deactivate the first switch at a first time to end the first duration. The control circuit is further configured to activate the second switch at a second time later than the first time for a second duration. The control circuit is further configured to control a delay between the first time and the second time. The second time corresponds to an end of a period during which the coil current flows through the second diode following deactivation of the first switch.

According to another aspect of the present disclosure, a system for controlling an inverter includes a first switch and a second switch connected to a resonant load. The resonant load includes an inductive load. The first and second switches are operable to supply the inductive load an electric current in alternation. A first diode is in antiparallel connection with the first switch. A second diode is in antiparallel with the second switch. The system further includes a control circuit in communication with the first and second switches. The control circuit is further configured to activate the first switch for a first period of time. The control circuit is further configured to deactivate the first switch. The control circuit is further configured to activate the second switch for a second period of time. The control circuit is further configured to deactivate the second switch. The control circuit is further configured to define a first adjustable period of time starting at the time the first switch is deactivated and depending on the time duration of the current flowing in the second diode after the first switch has been deactivated. The control circuit is further configured to define a second adjustable period of time starting from the time at which the second switch is deactivated and depending on the time duration of the current flowing in the first diode after the second switch has been deactivated. The control circuit is further configured to activate the second switch when the first adjustable period of time elapses. The control circuit is further configured to activate the first switch when the second adjustable period of time elapses.

According to some aspects, a method for controlling an inverter for an inductive load includes activating a first switch of the inverter to cause an electric current to flow through the inductive load. The method further includes deactivating the first switch at a first time. The method further includes activating a second switch of the inverter following deactivation of the first switch. The method further includes deactivating the second switch at a second time. The method further includes conducting the electric current through a first diode antiparallel to the first switch during a first adjustable period starting at the second time and ending based on at least one time duration. The method further includes conducting the electric current through a second diode antiparallel to the second switch during a second adjustable period starting at the first time and ending based on the at least one time duration. The method further includes controlling activation of the second switch to align with when the first adjustable period elapses. The method further includes controlling activation of the first switch to align with when the second adjustable period elapses.

According to some aspects, the at least one time duration includes a first time duration of the electric current flowing through the first diode, and the first adjustable time ends based on the first time duration.

According to some aspects, the at least one time duration includes a second time duration of the electric current flowing through the second diode, and the second adjustable time ends based on the second time duration.

According to yet another aspect of the present disclosure, a method for controlling an inverter includes providing a first switch and a second switch connected to a resonant load. The resonant load includes an inductive load. The first and second switches are operable to supply the inductive load an electric current in alternation. A first diode is in antiparallel connection with the first switch. A second diode is antiparallel with the second switch. The method further includes the execution of recursive sequential steps comprising activating the first switch for a first period of time, deactivating the first switch, activating the second switch for a second period of time, and deactivating the second switch. The method further includes defining a first adjustable period of time starting at the time the first switch is deactivated and depends on the time duration of the current flowing in the second diode after the first switch has been deactivated. The method further includes defining a second adjustable period of time starting from the time at which the second switch is deactivated and depending on the time duration of the current flowing in the first diode after the second switch has been deactivated. The step of activating the second switch is performed when the first adjustable period of time elapses. The step of activating the first switch is performed when the second adjustable period of time elapses.

According to yet another aspect, one or more of the first period of time, the second period of time, the first adjustable period of time, and the second adjustable period of time are part of a pulse-width modulated control and are dimensioned to deliver to the load a preset power level. The preset power level may be set by a user.

According to yet another aspect, one or more of the first period of time, the second period of time, the first adjustable period of time, and the second adjustable period of time are part of a Duty Cycle control and are dimensioned to deliver to the load a preset power level. The preset power level may be set by a user.

According to yet another aspect, the step of defining the first adjustable period of time includes the steps of measuring a first diode time starting from the time on which the first switch is deactivated and ending when a current flowing in the second diode is sensed to become substantially equal to zero. In some examples, the first diode time ends when the current flowing in the first diode is equal to zero.

According to yet another aspect, the step of defining the second adjustable period of time includes the steps of measuring a second diode time starting from the time on which the second switch is deactivated and ending when a current flowing in the first diode is sensed to become substantially equal to zero. In some examples, the second diode time ends when the current flowing in the first diode is equal to zero.

According to yet another aspect, the step of measuring the first and second diode times includes measuring an intensity and a polarity of an electric current flowing into the inductive load.

According to yet another aspect, the step of defining the first adjustable period of time results in further postponing the activation of the second switch by a time quantity equal to the first diode time when the first diode time is at least 5% of the first period of time. In some examples, the step of defining the first adjustable period of time results in further postponing the activation of the second switch by a time quantity equal to the first diode time when the first diode time is at least 10% of the first period of time.

According to yet another aspect, the step of defining the second adjustable period of time results in further postponing the activation of the first switch by a time quantity equal to the second diode time when the second diode time is at least 5% of the second period of time. In some examples, the step of defining the second adjustable period of time results in further postponing the activation of the first switch by a time quantity equal to the second diode time when the second diode time is at least 10% of the second period of time.

According to yet another aspect, the first adjustable period of time is equal to the first diode time when the first diode time is at least 5% of the first period of time. In some examples, the first adjustable period of time is equal to the first diode time when the first diode time is at least 10% of the first period of time.

According to yet another aspect, the second adjustable period is equal to the second diode time when the second diode time is at least 5% of the first period of time. In some examples, the second adjustable period is equal to the second diode time when the second diode time is at least 10% of the first period of time.

According to yet another aspect, the first and second adjustable periods of time are set to an equal duration. In some examples, the first and second adjustable periods of time are set equal to a maximum time duration between the first and second adjustable periods.

According to yet another aspect, when the first diode time is less than 5% of the first period of time, the first switch is activated after the current flowing in the second diode is sensed to become substantially equal to zero.

According to yet another aspect, when the second diode time is less than 5% of the second period of time, the second switch is activated after the current flowing in the first diode is sensed to become substantially equals to zero.

According to yet another aspect, the first and second adjustable periods are adjusted as preliminary steps of a power delivery cycle.

According to yet another aspect, the first and second adjustable periods are adjusted each time a variation of the resonant load condition is detected.

According to yet another aspect, the first and second adjustable periods are adjusted periodically along the life of the inverter in order to compensate aging of components.

It will be understood by one having ordinary skill in the art that construction of the described disclosure and other components is not limited to any specific material. Other exemplary embodiments of the disclosure disclosed herein may be formed from a wide variety of materials, unless described otherwise herein.

For purposes of this disclosure, the term "coupled" (in all of its forms, couple, coupling, coupled, etc.) generally means the joining of two components (electrical or mechanical) directly or indirectly to one another. Such joining may be stationary in nature or movable in nature. Such joining may be achieved with the two components (electrical or mechanical) and any additional intermediate members being integrally formed as a single unitary body with one another or with the two components. Such joining may be permanent in nature or may be removable or releasable in nature unless otherwise stated.

It is also important to note that the construction and arrangement of the elements of the disclosure as shown in the exemplary embodiments is illustrative only. Although only a few embodiments of the present innovations have been described in detail in this disclosure, those skilled in the art who review this disclosure will readily appreciate that many modifications are possible (e.g., variations in sizes, dimensions, structures, shapes, and proportions of the various elements, values of parameters, mounting arrangements, use of materials, colors, orientations, etc.) without materially departing from the novel teachings and advantages of the subject matter recited. For example, elements shown as integrally formed may be constructed of multiple parts or elements shown as multiple parts may be integrally formed, the operation of the interfaces may be reversed or otherwise varied, the length or width of the structures and/or members or connector or other elements of the system may be varied, the nature or number of adjustment positions provided between the elements may be varied. It should be noted that the elements and/or assemblies of the system may be constructed from any of a wide variety of materials that provide sufficient strength or durability, in any of a wide variety of colors, textures, and combinations. Accordingly, all such modifications are intended to be included within the scope of the present innovations. Other substitutions, modifications, changes, and omissions may be made in the design, operating conditions, and arrangement of the desired and other exemplary embodiments without departing from the spirit of the present innovations.

It will be understood that any described processes or steps within described processes may be combined with other disclosed processes or steps to form structures within the scope of the present disclosure. The exemplary structures and processes disclosed herein are for illustrative purposes and are not to be construed as limiting.

## Claims

1. A heating assembly for a cooking appliance comprising:
at least one induction coil (16);
a drive circuit (18) configured to control a coil current (60) through the at least one induction coil (16), the drive circuit (18) including a first switching circuit (34) operable to conduct the coil current (60) during a first conducting period and a second switching circuit (36) operable to conduct the coil current (60) during a second conducting period different than the first conducting period;
a sensing circuit (20) configured to detect a polarity of the coil current (60); and
a control circuit (22) in communication with the drive circuit (18) and the sensing circuit (20), the control circuit (22) configured to:
communicate a first activation signal to the first switching circuit (34) during a first activation period;
communicate a second activation signal to the second switching circuit (36) during a second activation period; and
control a delay between the first activation signal and the second activation signal based on the polarity of the coil current (60).

2. The heating assembly of claim 1, wherein the control circuit (22) is configured to communicate the first activation signal to a first switching device of the first switching circuit (34) and the second activation signal to a second switching device of the second switching circuit (36).

3. The heating assembly of claim 2, wherein the first activation signal corresponds to a high state of a first pulse-width modulation (PWM) signal (502) and the second activation signal corresponds to a high state of a second PWM signal (506).

4. The heating assembly of claim 3, wherein the control circuit (22) is further configured adjust a timing of a rising edge (526) of the second PWM signal (506) to control the delay.

5. The heating assembly of either one of claims 3 or 4, wherein the control circuit (22) is further configured to adjust a timing of a falling edge (524) of the first PWM signal (502) to control the delay.

6. The heating assembly of claim 1, wherein the control circuit (22) is further configured to:
calculate an interval (T₂) between a falling edge (528) of the first activation signal and a change in the polarity; and
adjust the second activation signal based on the change in the polarity.

7. The heating assembly of claim 6, wherein the first and second activation signals correspond to pulse-width modulation (PWM) signals (502, 506) having a plurality of cycles each defined by a pair of sequential first and second activation signals.

8. The heating assembly of claim 7, wherein the control of the delay is based further on the interval (T₂) of one or more of the plurality of cycles.

9. The heating assembly of claim 8, wherein the control circuit (22) is further configured to:
estimate a polarity transition time of the coil current (60) based on the interval (T₂) of the one or more of the plurality of cycles; and
adjust a rising edge (526) of the second activation signal to be temporally proximate to the polarity transition time.

10. The heating assembly of any one of claims 3-5, further comprising:
a first diode (D1) and a second diode (D2), wherein the first diode (D1) is configured to conduct the coil current (60) following deactivation of the second switching device and the second diode (D2) is configured to conduct the coil current (60) following deactivation of the first switching device.

11. The heating assembly of claim 10, wherein the controller (48) is further configured to:
determine that the coil current (60) is being conducted via the second diode (D2) based on the polarity of the coil current (60) and deactivation of the first switching device; and
activate the second switching device in response to the second diode (D2) not conducting the coil current (60) following deactivation of the first switching device.

12. The heating assembly of either one of claims 10 or 11, wherein the first diode (D1) is in parallel with the first switching device and the second diode (D2) is in parallel with the second switching device.

13. The heating assembly of claim 10, wherein the control circuit (22) is further configured to:
measure a diode time between deactivation of the second switching device and the first diode (D1) no longer conducting the coil current (60);
calculate a ratio of the diode time to the second activation time; and
postpone an activation of the first switching device based on the ratio of the diode time to the second activation time.

14. The heating assembly of claim 13, wherein the control circuit (22) is further configured to postpone the activation of the first switching device when the ratio corresponds to the diode time being at least 5% of the second activation time.

15. A method for controlling at least one induction coil (16) of a heating assembly for a cooking appliance, comprising:
controlling a coil current (60) through the at least one induction coil (16) via a drive circuit (18), the drive circuit (18) including a first switching circuit (34) operable to conduct the coil current (60) during a first conducting period and a second switching circuit (36) operable to conduct the coil current (60) during a second conducting period different than the first conducting period;
monitoring a polarity of the coil current (60) via a sensing circuit (20);
communicating a first activation signal to the first switching circuit (34) during a first activation period;
communicating a second activation signal to the second switching circuit (36) during a second activation period; and
controlling a delay between the first activation signal and the second activation signal based on the polarity of the coil current (60).
